Europäisches Patentamt

European Patent Office

Office européen des brevets

(11) Publication number: **0 316 886**
**A2**

## (12) EUROPEAN PATENT APPLICATION

(21) Application number: **88119051.6**

(22) Date of filing: **15.11.88**

(51) Int. Cl.4: **H05K 3/10**

(30) Priority: **16.11.87 JP 289114/87**

(43) Date of publication of application:
**24.05.89 Bulletin 89/21**

(84) Designated Contracting States:
**DE FR GB IT NL**

(71) Applicant: **FUJI KAGAKUSHI KOGYO CO., LTD.**
**8-43, Utajima 4-chome, Nishi Yodogawa-ku**
**Osaka-shi, Osaka 555(JP)**

(72) Inventor: **Miyai, Kazuo**
**8-43, Utajima 4-chome**
**Nishi Yodogawa-ku Osaka(JP)**

(74) Representative: **Patentanwälte Dr. Solf & Zapf**
**Zeppelinstrasse 53**
**D-8000 München 80(DE)**

(54) **Printed circuit board manufacturing method.**

(57) A printed circuit board manufacturing method which uses a thermal transfer ink ribbon prepared by coating a film with a thermoplastic layer of ink having a selected thickness and including a conductive filler such as carbon black mixed and dispersed in a thermoplastic vehicle. The thermal transfer ink ribbon is pressed upon a substrate base by a heating head having fine dots, with the fine dots heated selectively. The thermoplastic ink layer is thereby fused or softened for transfer to the substrate base and forming a circuit pattern on the substrate base.

EP 0 316 886 A2

## PRINTED CIRCUIT BOARD MANUFACTURING METHOD

### BACKGROUND OF THE INVENTION

The present invention relates to a printed circuit board manufacturing method for forming a circuit pattern on an insulating substrate by utilizing a conductive material.

Known printed circuit board manufacturing methods are broadly classified into the following subtractive method (etching) and additive method (plating):

[Subtractive Method]

A laminate board formed by applying copper foil to an insultaing substrate is surfacially coated only at positions corresponding to a circuit pattern with an acid-resistant material (etching resist). Next, a chemical (etching solution) which dissolves copper is jetted to the copper foil surface to dissolve and remove the portion of copper foil not intended to form the circuit pattern. Then the etching resist is removed by using a chemical, thereby exposing the circuit pattern (copper foil surface).

[Additive Method]

A plating resist is applied to the surface of an insulating substrate (laminate board without copper foil) excluding the portion corresponding to a circuit pattern. Thereafter electroless copper plating is affected. As a result, the circuit pattern is formed by the copper plating since the resist applied in the preceding step is not plated. Next, the plating resist is removed by using a chemical, thereby exposing the circuit pattern.

In the subtractive method, the printed circuit board is manufactured through a complicated process including application of a resist, etching and removal of the resist. The additive method also includes complicated steps such as application of a resist, electroless copper plating and removal of the resist. Thus, a high degree of engineering skill and expensive manufacturing equipment are required in executing either method. In addition, a neutralizing or COD treatment must be carried out on the exhaust liquids resulting from the manufacturin process. These requirements tend to raise the manufacturing cost of the printed circuit board.

A conductive coating method has been developed to solve the above problem and is attracting attention in recent years. This method is for printing a circuit pattern directly on an insultaing substrate by screen printing. However, it is difficult to form a fine pattern having a conductor width not exceeding 0.1mm by means of screen printing. There is room for improvement in this respect.

### SUMMARY OF THE INVENTION

The present invention intends to eliminate the disadvantages of the known manufacturing method noted above, and its object is to provide a printed circuit board manufacturing method which is advantageous in equipment and cost and capable of forming fine circuit patterns having a conductor width not exceeding 0.1mm.

This object is achieved, according to the present invention, by a printed circuit board manufacturing method comprising the steps of preparing a thermal transfer ink ribbon by coating a film with a thermoplastic layer of ink having a selected thickness and an electric resistance necessary for forming a conductive circuit, the layer of ink including a conductive filler such as conductive carbon black, graphite, silver and aluminium, and mixed and dispersed in a thermoplastic vehicle which is solid at room temperature, and causing a heating head having fine dots to press the thermal transfer ink ribbon upon substrate base and selectively heating the fine dots, thereby fusing or softening the layer of ink of the ink ribbon for transfer to the substrate base and forming a circuit pattern with the thermoplastic ink on the substrate base.

In the above method, the ink ribbon is pressed upon the substrate base by the fine dots of the heating head. In this state, the fine dots are selectively heated whereby the thermoplastic ink layer is fused or softened at positions pressed by the fine dots, for transfer to the substrate base. Since ink is transferred without spreading, a fine circuit pattern is formed having a very small width substantially corresponding to the diameter of the fine dots.

Various commercially available heating dots have a dot diameter not exceeding 100 micrometers. Therefore a circuit pattern may be formed to have a very small width not exceeding 0.1mm.

As noted above, the method according to the present invention places the thermal transfer ink ribbon having the conductive and thermoplastic ink layer between the substrate base and the heating head, and selectively heats the fine dots while pressing the fine dots successively from on conductive circuit forming position to another of the substrate base. As a result, a conductive circuit having a predetermined pattern is formed on the substrate. This method provides a simpler manufacturing process than the known subtractive and additive methods, and does not require expensive manufacturing equipment or exhaust liquid treating equipment. Consequently, circuit patterns may be formed with advantages in equipment and cost.

Moreover, a circuit pattern having a conductor width not exceeding 0.1mm may be formed by using heating dots having a dot diameter not exceeding 100 micrometers, for example. The feature enables fine pattern formation which has been impossible with the foregoing conductive coating method.

Other functions and advantages of the present method will be apparent from the following description.

BRIEF DESCRIPTION OF THE DRAWINGS

The drawings illustrate a method of manufacturing printed circuit boards according to the present invention, in which:-

Fig. 1 is an enlarged sectional view of a thermal transfer ink ribbon,

Fig. 2 is a front view showing an ink transfer operation,

Fig. 3 is a perspective view showing an example of circuit pattern, and

Fig. 4 is an enlarged sectional view of a modified thermal transfer ink ribbon.

DESCRIPTION OF THE PREFERRED EMBODIMENT

A method of manufacturing printed circuit boards according to the present invention will be described hereinafter.

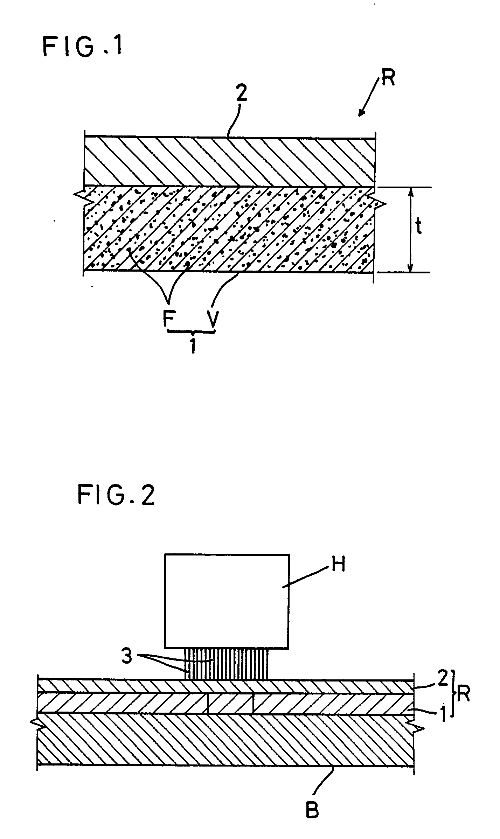

Referring to Fig. 1, this method uses a thermal transfer ink ribbon R comprising a layer of thermoplastic ink 1 coated in a predetermined thickness t on a film 2. The ink layer 1 includes a conductive filler F such as conductive carbon black, graphite or silver dispersed in a thermoplastic vehicle V which is solid at room temperature. The ink layer 1 thus has an electric resistance necessary for forming a conductive circuit. As shown in Fig. 2, this thermal transfer ink ribbon R is placed between a heating head H having fine dots 3 and an insulating substrate base B.

In this state, the heating head H is moved toward the substrate base B to press the ink ribbon R upon a circuit forming position of the substrate base B. Then the heating head H selectively heats the fine dots 3, whereby the ink layer 1 becomes fused or soft at positions in pressure contact with the heated fine dots 3 to be transferred to the substrate base B. Since any inadvertent spread of the ink during the transfer operation is not likely to occur, the ink layer 1 is transferred in a very small width approximately corresponding to the diameter of the fine dots 3.

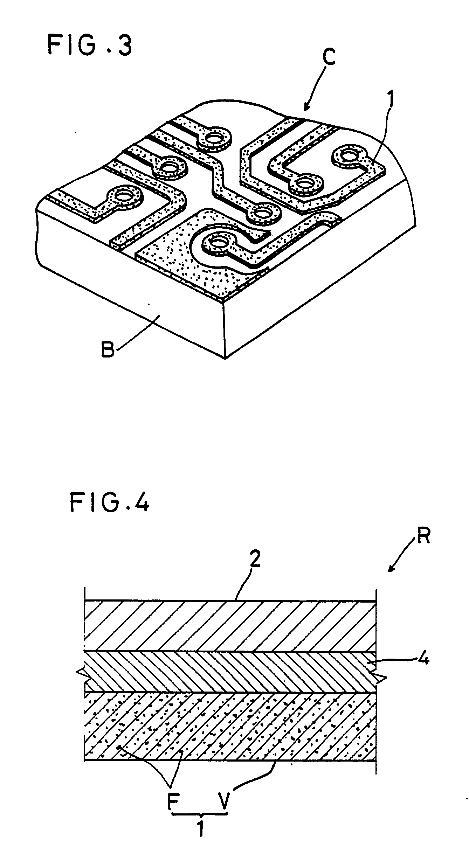

This transfer operation is carried out continuously by moving the fine dots 3 of the heating head H along the circuit forming positions of the substrate base B. Consequently, a predermined circuit pattern C is formed on the substrate base B as shown in Fig. 3.

The vehicle V comprises a material selected from various types of wax, oligomer and thermoplastic resin, or a mixture thereof which has a fusing or softening point from $50\degree$C up to about $200\degree$C, and employs, as necessary, appropriate oil as a softening agent or a filler dispersant. The ink layer 1 may have excellent adhesion where a synthetic product such as chlorinated polyethylene or paraffin chloride in particular is mixed therein.

A filler such as graphite, conductive carbon, silver, copper or aluminum may be mixed and dispersed in the vehicle V of the above composition to constitute a circuit forming material having appropriate conductivity.

It has been found through various experiments that the conductive filler F should be contained in the vehicle V preferably in an amount ranging from 5 to 70 vol.% of the entire ink layer 1. Where the conductive filler F is contained in an amount exceeding 70 vol.% of the entire ink layer 1, the circuit pattern has a reduced abrasion resistance. Where the conductive filler F is contained in an amount less than 5 vol.%, the circuit pattern has insufficient conductivity. The conductivity is variable with the resistance of the filler F itself which depends on the type of filler, the aspect ratio of filler particles, the width of the conductor forming the circuit and so on. It has been found that, if all of these factors work favorably, desired conductivity may be obtained even where the amount of conductive filler F is about 5 vol.% of the entire ink layer. However, in a normal situation, 30 vol.% or thereabouts is a desirable amount of the filler for realizing a reasonably high conductivity. An optimal amount of the filler is in the order of 50 vol.% having regard to both high conductivity and excellent abrasion resistance.

Typical examples of the various experiments conducted will be desired below.

(Experiment 1)

A thermal transfer ink ribbon R was manufactured by applying to a 6 micrometer thick polyester film 2 a 10 micrometer thick thermoplastic ink layer 1 having a $68\degree$C fusing point and including a thermoplastic ethylene-vinyl acetate copolymer and polyethylene wax as main components and graphite mixed thereinto in 50 vol.% as the conductive filler F.

The substrate base B comprised a sheet as one example of receptor which was formed by lightly bonding a 10 micrometer thick polyester film to a cardboard. The circuit pattern C was printed on the polyester film of the base B by operating a commercially available thermal printer employing a thermal head H having resistance elements arranged in a 16 dots/mm density.

As a result, the circuit pattern C was formed on the 10 micrometer thick polyester film of the base B with a 0.20mm center-to-center distance between conductors and a 0.08mm line width.

No dielectric breakdown occurred when an appropriate current was applied to the printed circuit board thus formed.

In order to protect the circuit pattern C, solid printing was effected on the pattern and surrounding areas by using an ink ribbon having an ink layer not containing the conductive filler F. This step resulted in a substrate having excellent insulation provided by the insulating ink covering the circuit.


(Experiment 2)

A thermal transfer ink ribbon R was manufactured by applying a 5 micrometer thick ink layer 4 including paraffin chloride as a main component and not including the conductive filler F to a 6 micrometer thick polyester film 2, and then applying thereto an 8 micrometer thick thermoplastic ink layer 1 including a thermoplastic polyamide resin as a main component with aluminum powder mixed thereinto in 50 vol.% as the conductive filler F. A circuit pattern was printed as in Experiment 1, with the result that thickening of the line was minimized and excellent abrasion resistance was achieved, thereby rendering overcoating unnecessary.

The thermal head having fine resistive heating elements was used in Experiment 1. However, the method according to the present invention may be executed by using, in combination with a thermoplastic ink ribbon R having a resistive layer, an electrifying head H including an arrangement of a plurality of fine electrodes to apply a current for heating the resistive layer to a sufficient degree for effecting thermal transfer.

Further, the heating head H may comprise a laser head for applying a laser beam as an energy necessary for transferring the thermoplastic ink layer 1.

## Claims

1. A printed circuit board manufacturing method comprising the steps of preparing a thermal transfer ink ribbon (R) by coating a film (2) with a thermoplastic layer of ink (1) having a selected thickness (t) and an electric resistance necessary for forming a conductive circuit, said layer of ink (1) including a conductive filler (F) mixed and dispersed in a thermoplastic vehicle (V) which is solid at room temperature, and causing a heating head (H) having fine dots (3) to press said thermal transfer ink ribbon (R) upon a substrate base (B) and selectively heating said fine dots (3), thereby fusing or softening said layer of ink (1) of said ink ribbon (R) for transfer to said substrate base (B) and forming a circuit pattern (C) with the thermoplastic ink (1) on said substrate base (B).

2. A printed circuit board manufacturing method as claimed in Claim 1, wherein an ink ribbon having a conductive thermoplastic layer of ink (1) is used as said thermal transfer ink ribbon (R) in combination with a thermal printer, said thermal printer being operated under control to form said circuit pattern (C) on said substrate base (B).

3. A printed circuit board manufacturing method as claimed in Claim 2, wherein said conductive filler (F) is selected from conductive carbon black, graphite, silver and aluminium, and contained in said vehicle (V) in an amount ranging from 5 to 70 vol.% of the entire ink layer.

4. A printed circuit board manufacturing method as claimed in any one of Claim 3, wherein a thermal head having fine resistive heating elements is used as said heating head (H).

5. A printed circuit board manufacturing method as claimed in Claim 4, wherein said thermal head includes a multiplicity of resistive elements.

6. A printed circuit board manufacturing method as claimed in any one of Claim 1, wherein said thermal transfer ink ribbon (R) has a resistive layer, and said heating head (H) comprises an electrifying head having fine electrodes for applying current to said resistive layer to generate sufficient heat for thermal transfer.

7. A printed circuit board manufacturing method as claimed in Claim 6, wherein said electrifying head includes a multiplicity of fine electrodes.

8. A printed circuit board manufacturing method as claimed in any one of Claim 1, wherein said heating head (H) comprises a laser head for providing a laser beam as energy necessary for transferring said thermoplastic layer of ink (1).

# FIG.1

# FIG.2

FIG.3

FIG.4